## Europäisches Patentamt

## European Patent Office

## Office européen des brevets

(11) Veröffentlichungsnummer: **0 354 489 B1**

(12) **EUROPÄISCHE PATENTSCHRIFT**

(45) Veröffentlichungstag der Patentschrift: **23.11.94**

(21) Anmeldenummer: **89114454.5**

(22) Anmeldetag: **04.08.89**

(51) Int. Cl.⁵: **C09D 183/04**, B05D 7/26

(54) **Verfahren zum Beschichten von Substraten mit einem isolierenden Überzug.**

(30) Priorität: **05.08.88 DE 3826715**

(43) Veröffentlichungstag der Anmeldung:
**14.02.90 Patentblatt 90/07**

(45) Bekanntmachung des Hinweises auf die
Patenterteilung:
**23.11.94 Patentblatt 94/47**

(84) Benannte Vertragsstaaten:
**AT BE CH DE ES FR GB GR IT LI LU NL SE**

(56) Entgegenhaltungen:
**EP-A- 0 352 339**
**US-A- 3 840 393**

(73) Patentinhaber: **FRAUNHOFER-GESELLSCHAFT ZUR FÖRDERUNG DER ANGEWANDTEN FOR- SCHUNG E.V.**
**Leonrodstrasse 54**
**D-80636 München (DE)**

(72) Erfinder: **Wolter, Herbert, Dr.**
**Steinstrasse 21**
**D-6975 Gerchsheim (DE)**
Erfinder: **Schmidt, Helmut, Dr.**
**Am Schlosssand 9**
**D-8705 Zellingen (DE)**

(74) Vertreter: **Barz, Peter, Dr. et al**
**Patentanwälte Dipl.-Ing. G. Dannenberg**
**Dr. P. Weinhold, Dr. D. Gudel**
**Dipl.-Ing. S. Schubert, Dr. P. Barz**
**Siegfriedstrasse 8**
**D-80803 München (DE)**

**Beschreibung**

Die vorliegende Erfindung betrifft ein Verfahren zum Beschichten von elektrisch leitfähigen Substraten, insbesondere Metallkernen von Leiterplatten, mit einem isolierenden Überzug und einen in diesem Verfahren einsetzbaren härtbaren Isolationslack.

Bei einer Leiterplatte handelt es sich um einen Träger für elektronische Bauteile und die sie verbindenden metallischen Leiterbahnen. Ein großer Anteil der Nachfrage an Basis-Materialien für derartige Leiterplatten wird durch glasfaserverstärkte Epoxidharzplatten (FR-4) abgedeckt. Durch eine kontinuierliche Zunahme der Packungsdichte der elektronischen Bauteile und durch die Automatisierung der Bestückung werden qualitativ immer höhere Anforderungen an das Basis-Material gestellt.

Wichtige Kriterien hierbei sind:

(a) Hohe Wärmeleitfähigkeit $\lambda$, um die von den Bauteilen produzierte Wärme schnell ableiten zu können;

(b) Hohe Oberflächen- und Durchgangswiderstände, kleine Dielektrizitätskonstante $\epsilon$, kleiner Verlustwinkel $\tan\delta$, sowohl im Trocken- als auch im Feuchtklima;

(c) Gute thermische und Dimensionsstabilität;

(d) Günstige Produktionsbedingungen und gute Bearbeitbarkeit;

(e) Hohe chemische Stabilität (gegenüber Metallisierungschemikalien).

Substratmaterialien auf der Basis von organischen Polymeren können die zunehmenden Anforderungen auch in Verbindung mit Metallkernen (bessere Wärmeabführung) nicht umfassend erfüllen; so zeigen z.B. FR-4-Platten die folgenden (relativ unbefriedigenden) Werte:

$\lambda$ = 0,16 W/m x K; Tg = 130°C; $\epsilon$ = 4,5 und $\tan\delta$ = 23 x $10^{-3}$ (jeweils bei 1 kHz).

Wie bereits oben erwähnt, werden heute Trägermaterialien benötigt, die unter anderem die von den Bauteilen produzierte Wärme schnell ableiten können, um eine einwandfreie Funktion, insbesondere bei hoher Bestückungsdichte zu gewährleisten.

Als ideale Wärmeleiter bieten sich metallische Werkstoffe an. Da diese im allgemeinen ebenfalls ausgezeichnete elektrische Leiter sind, kann man die Leiterbahnen erst aufbringen, nachdem man das Substratmaterial in geeigneter Weise isoliert hat. Selbstverständlich muß der isolierende Überzug besonders hinsichtlich der Metallisierung der Leiterplatte beständig sein, d.h. er darf insbesondere nicht von den Chemikalien angegriffen werden, die im Rahmen der Aufbringung von z.B. einer Kupferschicht und der späteren Entfernung der nicht benötigten Teile dieser Schicht (z.B. durch Ätzen) eingesetzt werden müssen.

Die EP-A-352 339, ein gemäß Art. 54(3) EPÜ relevantes Dokument, beschreibt eine Beschichtungszusammensetzung, in der zwar (teilweise) hydrolysierbare Siliciumverbindungen eingesetzt werden, jedoch nicht solche, die über Gruppen verfügen, die durch Protonierung oder Deprotonierung in geladene Gruppen umgewandelt werden können (z.B. Amino- oder Säuregruppen).

In der US-A-3 840 393 wird ein Vinyl-haltiger Organopolysiloxan-Lack für die Beschichtung eines Isolators beschrieben. Dieser Lack wird zwingend unter Verwendung eines (zuvor herzustellenden) oligomeren bzw. polymeren Siloxans (mit 5 bis 111 Siliciumatomen) hergestellt.

Ziel der vorliegenden Erfindung ist es, ein Verfahren zur Verfügung zu stellen, das es ermöglicht, elektrisch leitfähige Substrate mit einem isolierenden Überzug zu versehen, der die oben erwähnten hohen Anforderungen an die thermische und chemische Stabilität und an die elektrischen Eigenschaften erfüllen kann.

Gegenstand der vorliegenden Erfindung ist demgemäß ein Verfahren zum Beschichten von elektrisch leitfähigen Substraten mit einem isolierenden Überzug, bei dem man mindestens zwei Siliciumverbindungen A, die jeweils mindestens eine an Silicium gebundene OH-Gruppe und/oder hydrolyseempfindliche Gruppe X, die ausgewählt ist aus Wasserstoff, Halogen, gegebenenfalls mit bis zu 3 Halogenen und $C_{1-4}$-Alkoxyresten substituiertem $C_{1-4}$-Alkoxy sowie $C_{1-4}$-Acyloxy und $NR'_2$ (R' = H und/oder $C_{1-4}$-Alkyl), aufweisen, wobei mindestens eine dieser Silicium-Verbindungen zusätzlich mindestens einen Rest Y besitzt, der über mindestens eine Kohlenstoff-Kohlenstoff-Doppel- oder Dreifachbindung verfügt, und mindestens eine dieser Siliciumverbindungen mindestens einen Rest Z aufweist, der über eine Gruppe verfügt, die ausgewählt ist aus Gruppen der Formeln $-NR'_2$, $-SO_3H$ und $-COOH$, oder ein entsprechendes Oligomeres einer Polykondensation unterwirft, das resultierende Polykondensat als solches auf das Substrat aufbringt und den so erhaltenen Überzug durch Polymerisation unter Beteiligung der Reste Y aushärtet.

Elektrisch leitfähige Substrate sind im erfindungsgemäßen Verfahren insbesondere Metalle, wenn auch andere leitfähige Materialien, wie z.B. leitfähige Polymere, erfindungsgemäß beschichtet werden können.

Als zu beschichtende Metalle werden erfindungsgemäß Aluminium, Kupfer, Eisen, Zink, Chrom, Nickel, Blei, Zinn, Titan, Vanadium und Silber sowie die entsprechenden, diese Metalle enthaltenden Legierungen, insbesondere Edelstähle, bevorzugt. Besonders bevorzugt werden Aluminium, Kupfer, Eisen und Eisenlegierungen (Edelstahl).

Hinsichtlich der in den Siliciumverbindungen A anwesenden Gruppen sind neben Hydroxygruppen repräsentative Gruppen X Wasserstoff; Chlor und Brom; Methoxy, Ethoxy, n-, i-Propoxy, n-, i-, sek-Butoxy ; Acetoxy und Propionyloxy.

Konkrete Beispiele für Gruppen Y sind Vinyl, 1- und 2-Propenyl, Butenyl, Isobutenyl, Styryl, (Meth)-acryloxy-$C_{1-4}$-alkyl, insbesondere Methacryloxypropyl.

Konkrete Beispiele für Reste Z, insbesondere die (vorzugsweise an einen aliphatischen oder aromatischen Kohlenwasserstoffrest gebundene) Gruppe $NR_2'$ sind $-NH_2$, $-N(CH_3)_2$ und $-N(C_2H_5)_2$. Die beiden letztgenannten Gruppen werden insbesondere dann eingesetzt, wenn eine möglichst geringe Wasserlöslichkeit des resultierenden Polykondensats gewünscht wird. Andere erfindungsgemäß verwendbare Reste Z sind $-COOH$ und $-SO_3H$, die im Gegensatz zu den oben genannten Aminogruppen zu einem negativ geladenen Polykondensat führen können.

Vorzugsweise umfassen die Siliciumverbindungen A auch mindestens eine Verbindung, die über weichmachende Gruppen V verfügt. Diese Gruppen dienen dazu, dem gehärteten Überzug eine gewisse Elastizität zu verleihen, die erforderlich sein kann, um die unterschiedlichen Wärmeausdehnungskoeffizienten von Überzug und Substrat auszugleichen. Bevorzugte Gruppen V sind Gruppen mit einem aromatischen Rest, insbesondere Phenyl, Tolyl, Xylyl und Benzyl. Selbstverständlich kann der Phenylrest außer mit Alkylgruppen auch mit anderen Gruppen, wie z.B. Halogen oder Nitro, substituiert sein. Die am meisten bevorzugte Gruppe V ist jedoch der unsubstituierte Phenylrest.

Neben den oben genannten Gruppen X, Y, Z und V umfassen die monomeren Siliciumverbindungen A gegebenenfalls auch andere Reste R, vorzugsweise gesättigte aliphatische Kohlenwasserstoffreste mit vorzugsweise 1 bis 8, insbesondere 1 bis 4 Kohlenstoffatomen, wie z.B. Methyl, Ethyl, n-, i-Propyl, n-, i-, sek- und tert-Butyl, und cycloaliphatische Reste mit 4 bis 8 Kohlenstoffatomen, insbesondere Cyclopentyl und Cyclohexyl. Diese Reste können gegebenenfalls auch Substituenten tragen, z.B. Halogen oder $C_{1-4}$-Alkoxy.

Vorzugsweise sind die Reste der soeben genannten Kategorien in den monomeren Siliciumverbindungen A in folgenden Mengen, bezogen auf die Gesamtmolzahl dieser Gruppen vorhanden:

35 bis 75 Molprozent, vorzugsweise 45 bis 60 Molprozent, und insbesondere 50 bis 55 Molprozent Gruppen X und/oder OH-Gruppen;

5 bis 30 Molprozent, vorzugsweise 10 bis 20 Molprozent, und insbesondere 12 bis 18 Molprozent Gruppen Y;

bis zu 10 Molprozent, vorzugsweise bis zu 5 Molprozent, und insbesondere bis zu 3 Molprozent Gruppen Z;

5 bis 30 Molprozent, vorzugsweise 10 bis 20 Molprozent, und insbesondere 12 bis 18 Molprozent Gruppen V;

0 bis 30 Molprozent, vorzugsweise 5 bis 25 Molprozent, und insbesondere 10 bis 20 Molprozent Gruppen R.

Spezielle Beispiele für (zum Großteil im Handel erhältliche) Siliciumverbindungen A, die eingesetzt werden können, um die obigen Verhältnisse zu realisieren, sind:

(a) $\gamma$-Methacryloxypropyltrimethoxysilan, Vinyltrichlorsilan, Methylvinyldichlorsilan, Vinyltrimethoxysilan, Vinyltriethoxysilan und Vinyl-tris($\beta$-methoxyethoxy)silan; wegen der in diesen Verbindungen vorhandenen Gruppen Y sind diese Verbindungen insbesondere für die organische Vernetzung (Härtung) des Isolationslacks von Bedeutung;

(b) Diphenyldichlorsilan, Diphenyldimethoxysilan und Diphenyldiethoxysilan; wegen der in diesen Verbindungen vorhandenen Gruppen V werden diese Verbindungen eingesetzt, um dem fertigen Überzug eine gewisse Elasizität zu verleihen;

(c) $SiCl_4$, $Si(OCH_3)_4$, $Si(OC_2H_5)_4$, $Si(n-$ oder $i-OC_3H_7)_4$ und $Si(OC_4H_9)_4$; derartige Verbindungen, die nach der Hydrolyse zu dreidimensionalen Verknüpfungsstellen im Polykondensatnetzwerk führen, werden vorzugsweise eingesetzt, um dem fertigen Überzug eine gewisse Härte (Kratzfestigkeit) zu verleihen;

(d) $\gamma$-Aminopropyltrimethoxysilan, $\gamma$-Aminopropyltriethoxysilan, $\gamma$-Aminopropylmethyldiethoxysilan, N-$\beta$-Aminoethyl-$\gamma$-aminopropyltrimethoxysilan und die entsprechenden N-Mono- bzw. N,N-Di-methyl- bzw. -ethyl-silane; aufgrund der in diesen Verbindungen vorhandenen Reste Z werden diese Verbindungen besonders dann verwendet, wenn das Polykondensat durch Elektrotauchlackierung auf das Substrat aufgebracht werden soll.

Weitere erfindungsgemäß verwendbare Siliciumverbindungen A, die sich nach bekannten Methoden herstellen lassen (vgl. W. Noll, "Chemie und Technologie der Silicone", Verlag Chemie GMBH, Weinheim/Bergstraße (1968)) sind z.B.:

$(CH_3)_2SiCl_2$, $(CH_3)_2Si(OCH_3)_2$, $(CH_3)_2Si(OC_2H_5)_2$

$CH_2=CH-CH_2-Si(OC_2H_5)_3$

$CH_2=CH-CH_2-Si(OOCCH_3)_3$

$(i-C_3H_7)_3SiOH$, $(CH_3)_2Si(OH)_2$

$HSiCl_3$, $Si(OOCCH_3)_4$

$(C_2H_5O)_3SiCH_2-NH_2$

$(C_2H_5O)_3Si-p-C_6H_4-NH_2$

$(CH_3)(CH_3O)_2Si-CH_2-CH(CH_3)-CH_2-NH-(CH_2)_2-NH_2$

$CH_3(C_2H_5O)_2Si-(CH_2)_4-NH_2$

$(CH_3)_2(C_2H_5O)Si-CH_2-NH_2$

$(CH_3)(C_2H_5O)_2Si-CH_2-NH_2$

Vorzugsweise werden die Verbindungen der Gruppen (a) bis (d) in den folgenden Mengen, bezogen auf die Gesamtmolzahl der eingesetzten Verbindungen A, verwendet:

55 bis 75 Molprozent, insbesondere 60 bis 70 Molprozent, Verbindungen der Gruppe (a);

24 bis 40 Molprozent, insbesondere 29 bis 35 Molprozent, Verbindungen der Gruppe (b);

1 bis 5 Molprozent, insbesondere 1 bis 3 Molprozent, Verbindungen der Gruppe (c);

bis zu 10 Molprozent, insbesondere bis zu 7 Molprozent, Verbindungen der Gruppe (d).

Statt der Siliciumverbindungen A oder eines Teils dieser Verbindungen können auch bereits entsprechende Oligomere bzw. Vorkondensate im erfindungsgemäßen Verfahren Verwendung finden.

Neben den Siliciumverbindungen A können hydrolytisch polykondensierbare Verbindungen mit von Silicium verschiedenen Zentralatomen eingesetzt werden. Diese Verbindungen machen vorzugsweise aber weniger als 40 Molprozent, insbesondere weniger als 20 Molprozent aller eingesetzten Ausgangsverbindungen aus. Bevorzugte Beispiele für von Silicium verschiedene Zentralatome sind Aluminium, Titan, Zirkon, Vanadium, Zinn, Blei und Bor. Als Verbindungen mit derartigen Zentralatomen kommen insbesondere solche in Frage, die über Reste der Kategorien X, Y, Z, V und R, wie sie oben definiert werden, verfügen. Es muß jedoch darauf geachtet werden, daß durch die Mitverwendung derartiger von den Verbindungen A verschiedener Verbindungen die gewünschten Eigenschaften, insbesondere die chemischen und elektrischen Eigenschaften, der resultierenden isolierenden Überzüge nicht merklich beeinträchtigt werden.

Die Herstellung des erfindungsgemäß auf das Substrat aufzubringenden Polykondensats kann in auf diesem Gebiet üblicher Art und Weise erfolgen. So kann man z.B. die Ausgangsverbindungen (insbesondere die Verbindungen A) zunächst in einem geeigneten (polaren) Lösungsmittel, wie z.B. Ethanol oder Isopropanol, lösen und diese Lösung dann bei -20 bis 130°C, vorzugsweise zwischen 0°C und dem Siedepunkt des Lösungsmittels und insbesondere bei Raumtemperatur, mit mindestens der zur Hydrolyse theoretisch erforderlichen stöchiometrischen Menge, bevorzugt aber mit einem Überschuß, Wasser in Kontakt bringen. Die beste Art und Weise des Inkontaktbringens hängt unter anderem vor allem von der Reaktivität der eingesetzten Ausgangsverbindungen ab. So kann man z.B. die gelösten Ausgangsverbindungen langsam zu einem Überschuß an Wasser tropfen oder man gibt Wasser in einer Portion oder portionsweise den gelösten Ausgangsverbindungen zu. Es kann auch nützlich sein, das Wasser nicht als solches zuzugeben, sondern mit Hilfe von wasserhaltigen organischen oder anorganischen Systemen in das Reaktionssystem einzutragen. Als besonders geeignet hat sich in vielen Fällen die Eintragung der Wassermengen in das Reaktionsgemisch mit Hilfe von feuchtigkeitsbeladenen Adsorbentien, z.B. Molekularsieben, und wasserhaltigen organischen Lösungsmitteln, z.B. 80%igem Ethanol, erwiesen. Die Wasserzugabe kann auch über eine Reaktion erfolgen, bei der Wasser gebildet wird, z.B. bei der Esterbildung aus Säure und Alkohol (CCC = Chemically Controlled Condensation).

Als Lösungsmittel kommen neben den oben genannten bevorzugt verwendeten niederen aliphatischen Alkoholen auch Ketone, vorzugsweise niedere Dialkylketone, wie Aceton und Methylisobutylketon, Ether, vorzugsweise niedere Dialkylether, wie Diethylether, THF, Amide, wie Dimethylformamid, und deren Gemische in Frage.

Die Polykondensation erfolgt gegebenenfalls und vorzugsweise unter Zusatz eines Katalysators, z.B. einer Protonen oder Hydroxyionen abspaltenden Verbindung oder eines Amins. Beispiele für geeignete Katalysatoren sind organische oder anorganische Säuren, wie Salzsäure und Essigsäure, organische oder anorganische Basen, wie Ammoniak, Alkali- und Erdalkalimetallhydroxide, z.B. Natrium-, Kalium- oder Calciumhydroxid, und wasserlösliche Amine, wie Triethylamin. Besonders bevorzugt sind basische Katalysatoren, wie z.B. Alkalimetallhydroxide, da diese zu einer sehr vollständigen Kondensation führen, d.h. zu einem Produkt (Polykondensat), das vorzugsweise über praktisch keine (unkondensierten) OH-Gruppen mehr verfügt. Dies ist sowohl im Hinblick auf die elektrischen Eigenschaften als auch im Hinblick auf die chemische Stabilität des fertigen Überzugs von Vorteil, da die Anwesenheit von OH-Gruppen den Angriff von Säuren und Basen, aber auch von Wasser, auf den Überzug erleichtert.

Befinden sich unter den Ausgangsverbindungen A Halogensilane, insbesondere Chlorsilane, kann gegebenenfalls auf die Zugabe von Wasser für die Polykondensation vollkommen verzichtet werden. In

4

diesem Fall reicht es, wenn eine bezogen auf die anwesende Menge an Halogen stöchiometrische Menge an Base, insbesondere Alkali- oder Erdalkalihydroxid, zu den flüssigen Ausgangsverbindungen gegeben wird. Vorzugsweise wird dabei ein leichter Überschuß (z.B. 1,1- bis 1,5fach) an Base eingesetzt.

Die Ausgangsverbindungen A müssen nicht notwendigerweise bereits alle zur Beginn der Polykondensation vorhanden sein, sondern es genügt, wenn ein Teil dieser Verbindungen zunächst mit Wasser (bzw. Base) in Kontakt gebracht wird und später die restlichen Verbindungen zugegeben werden. Es wird jedoch bevorzugt, daß bereits zu Beginn der Polykondensation alle Ausgangsverbindungen anwesend sind, selbst wenn diese zunächst untereinander reagieren können wie dies z.B. im Falle der gleichzeitigen Anwesenheit von Chlorsilanen und Silanen mit Amingruppen der Fall sein kann.

Die Kondensationszeit richtet sich nach den jeweiligen Ausgangskomponenten und deren Mengenanteilen, dem verwendeten Katalysator, der Reaktionstemperatur etc. Im allgemeinen erfolgt die Polykondensation bei Normaldruck, sie kann jedoch auch bei erhöhtem oder verringertem Druck durchgeführt werden.

Nach der beendeten Polykondensation werden die gegebenenfalls vorhandenen anorganischen Bestandteile in geeigneter Weise vom Polykondensat abgetrennt. Dies kann z.B. dadurch geschehen, daß man bereits ausgefallene Salze abfiltriert, vom Filtrat das Lösungsmittel entfernt und den Rückstand als solchen oder gelöst in einem unpolaren Lösungsmittel (z.B. Petrolether), gründlich mit Wasser wäscht.

Alternativ dazu kann als Lösungsmittel für die Polykondensation ein wasserunlösliches Lösungsmittel (z.B. Petrolether Siedebereich 100 bis 140°C) verwendet werden, so daß das Reaktionsgemisch zur notwendigen Entfernung eventuell anwesender anorganischer Salze (z.B. Alkalihydroxide und Alkalihalogenide) direkt mit Wasser ausgeschüttelt werden kann.

Erfindungsgemäß ist es zur Gewährleistung zufriedenstellender chemischer und elektrischer Eigenschaften des resultierenden Überzugs sehr empfehlenswert, anorganische Verbindungen, Wasser, polare Hydrolyseprodukte und eventuell eingesetzte polare Lösungsmittel so vollständig wie möglich aus dem Polykondensat zu entfernen. Deshalb wird es bevorzugt, nach der gründlichen Wäsche des Polykondensats dieses zu trocknen und daraufhin über eine längere Zeitspanne, z.B. 0,5 bis 4 Stunden, einer erhöhten Temperatur, z.B. 120 bis 200°C, auszusetzen. Trocknung und Wärmebehandlung erfolgen vorzugsweise im Vakuum.

Das so erhaltene, gründlich von anorganischen Materialien befreite und getrocknete Polykondensat ist möglicherweise noch nicht ausreichend viskos, um einen befriedigenden Überzug zu liefern. Eine zu geringe Viskosität hat nämlich zur Folge, daß der Lack (das Polykondensat) nach dem Aufbringen auf das Substrat und vor der Härtung zum Verlaufen neigt, was zu einer ungleichmäßigen Beschichtungsdicke führen kann und deshalb unerwünscht ist. Erfindungsgemäß wird es deshalb in den meisten Fällen bevorzugt, die rheologischen Eigenschaften des Polykondensats, insbesondere dessen Zähigkeit (Viskosität) so einzustellen, daß das Polykondensat sich zwar noch im in der Regel verwendeten Beschichtungslösungsmittel zufriedenstellend löst, aber doch so viskos ist, daß es, einmal auf das Substrat aufgebracht, praktisch nicht mehr zum Verlaufen neigt. Die Einstellung der rheologischen Eigenschaften gelingt z.B. durch eine Vorhärtung (Vorvernetzung), die unter Bedingungen durchgeführt wird, die dazu führen, daß z.B. ein Teil der Gruppen Y (und gegebenenfalls der Gruppen R) bereits an einer Polymerisationsreaktion teilnehmen. Dies kann auf üblichem Wege bewerkstelligt werden, z.B. indem man das Polykondensat eine gewisse Zeit einer erhöhten Temperatur, vorzugsweise einer Temperatur zwischen 200 und 250°C aussetzt, bis sich dessen Viskosität im gewünschten Bereich befindet. Die Überwachung der Viskosität kann durch geeignete, für diesen Zweck wohl bekannte Apparaturen erfolgen. Der in den meisten Fällen günstigste Viskositätbereich kann aber auch rein empirisch bestimmt werden, indem man die Polymerisation (Vorvernetzung) zu dem Zeitpunkt abbricht, zu dem das erhitzte Polykondensat nicht mehr zu Tropfenbildung neigt, sondern Fäden zieht.

Will man das Polykondensat bei niedrigen Temperaturen oder gar bei Raumtemperatur vorvernetzen, empfiehlt es sich, kleine Mengen an thermischem Polymerisationskatalysator oder UV-Starter zuzugeben und die Vorvernetzung dann durch Temperaturerhöhung oder Belichtung mit UV-Licht einzuleiten.

In jedem Fall muß darauf geachtet werden, daß die Vorvernetzung nicht zu weit fortschreitet, da sonst eine sprödelastische Masse erhalten wird, die zu keinen klaren Lösungen mehr führt. Während der Vorvernetzung eventuell gebildete kleine Harzbröckchen können aber durch Filtration, gegebenenfalls nach Auflösen des Polßkondensats in einem geeigneten Lösungsmittel, entfernt werden.

Vor dem eigentlichen Beschichtungsvorgang wird die Oberfläche des zu beschichtenden Substrats vorzugsweise vorbehandelt, insbesondere gereinigt und eventuell aktiviert. Die Entgratung von Kanten ist empfehlenswert. Gegebenenfalls kann die Oberfläche vor der Beschichtung mit einem Haftvermittler (z.B. monomeren Silanen) behandelt werden. Ein geeigneter Primer insbesondere für Aluminiumoberflächen ist z.B. Aminopropyltrimethoxysilan.

Erfindungsgemäß kann das Aufbringen des (vorzugsweise vorvernetzten) Polykondensats auf das Substrat auf jede für diesen Zweck geeignete und bekannte Art und Weise erfolgen, z.B. durch Tauchen, Sprühen, Schleudern, Rakeln, Spritzen, elektrostatisches Spritzen etc. Eine Tauchbehandlung und insbesondere eine Elektrotauchlackierung werden jedoch bevorzugt.

Für die Beschichtung durch Tauchen wird das Polykondensat zweckmäßigerweise in einem geeigneten Lösungsmittel gelöst. In der Regel löst sich insbesondere das vorvernetzte Polykondensat nur in unpolaren bzw. wenig polaren Lösungsmitteln, so daß für diesen Zweck aliphatische und aromatische Kohlenwasserstoffe besonders gut geeignet sind. Toluol und die Xylole sind die am meisten bevorzugten Lösungsmittel, obwohl auch andere Lösungsmittel, z.B. Essigester oder Butylacetat, zu zufriedenstellenden Ergebnissen führen können.

Das Gewichtsverhältnis Polykondensat zu Lösungsmittel liegt vorzugsweise im Bereich von 0,5:1 bis 2:1, insbesondere von 0,75:1 bis 1,5:1. Das jeweils optimale Verhältnis hängt unter anderem auch von der gewünschten Schichtdicke ab. Es kann sich als vorteilhaft erweisen die gewünschte Schichtdicke nicht durch einen einzigen Tauchvorgang zu bewerkstelligen, sondern eine Mehrfachbeschichtung durch mehrmaliges Eintauchen in die Lacklösung durchzuführen. In diesem Zusammenhang ist es empfehlenswert vor jedem neuen Eintauchen eine Zwischenhärtung des Polykondensats durchzuführen, um dieses soweit zu vernetzen, daß sich dieses beim nächsten Eintauchvorgang vorzugsweise nicht mehr merklich in der Lacklösung löst. Eine Zwischenhärtung kann z.B. erfolgen, indem man die Beschichtung zuerst an der Luft trocknen läßt und dann für kurze Zeit, z.B. 10 bis 15 Minuten, auf erhöhte Temperatur, z.B. 200 bis 220°C, erhitzt. Bei der Zwischenhärtung sollte darauf geachtet werden, daß das Polykondensat nicht zu stark vernetzt, was eventuell dazu führen würde, daß bei der anschließenden Beschichtung die Lacklösung den bereits vorhandenen Überzug nicht mehr zufriedenstellend benetzt.

Nach dem einzigen oder letzten Tauchvorgang wird zweckmäßigerweise eine Endhärtung vorgenommen, z.B. indem man die Beschichtung zunächst an der Luft trocknen läßt und dann für eine längere Zeitspanne, z.B. 1 bis 2 Stunden, auf eine Temperatur im Bereich von 220 bis 270°C erhitzt. Die für den jeweiligen Einzelfall optimalen Bedingungen hängen unter anderem von der Zusammensetzung des Polykondensats (Ausgangsverbindungen A) und der Behandlung des Polykondensats vor der eigentlichen Beschichtung ab, können aber durch Routineversuche ohne weiteres ermittelt werden.

Wie für die Vorvernetzung gilt auch für die Zwischen- bzw. Endhärtung, daß nicht notwendigerweise Temperaturen über 200°C eingesetzt werden müssen. So kann man die erforderliche Temperatur z.B. durch Einsatz eines thermischen Polymerisationsinitiators, wie z.B. Benzoylperoxid, tert-Butylperbenzoat und Azobisisobutyronitril, erheblich senken. Wird eine Vernetzung bzw. Härtung bei Raumtemperatur gewünscht, so kann man z.B. auch einen UV-Starter einsetzen und die Härtung durch Bestrahlung mit UV-Licht durchführen. Für diesen Zweck geeignete Photoinitiatoren sind auf diesem Gebiet wohl bekannt. Lediglich beispielhaft seien die folgenden genannt: Irgacure 184 und andere von der Firma Ciba-Geigy erhältliche Photoinitiatoren vom Irgacure-Typ, Darocur 1173, 1116, 1398, 1174 und 1020 (erhältlich von der Firma Merck), Benzophenon 2-Chlorthioxanthon, 2-Methylthioxanthon, 2-Isopropylthioxanthon, Benzoin, 4'-Dimethoxybenzoin, Benzoinethylether, Benzoinisopropylether, Benzildimethylketal, 1,1,1-Trichloracetophenon, Diethoxyacetophenon und Dibenzosuberon.

Neben den oben explizit genannten thermischen Initiatoren können ganz allgemein organische Peroxide in Form von Diacylperoxiden, Peroxydicarbonaten, Alkylperestern, Dialkylperoxiden, Perketalen, Ketonperoxiden und Alkylhydroperoxiden verwendet werden.

Selbstverständlich kann z.B. auch ein Initiator verwendet werden, der zu einer ionischen Polymerisation Anlaß gibt.

Soll für die Zwischen- bzw. Endhärtung ein Initiator verwendet werden, so wird dieser zweckmäßigerweise bereits der Beschichtungslösung zugegeben.

Obwohl im Polykondensat erfindungsgemäß Gruppen Y und R vorhanden sind, die durch Polymerisation eine Vernetzung und somit Härtung des Überzugs bewirken können, ist es natürlich auch möglich, z.B. der Beschichtungslösung für die Tauchlackierung Verbindungen zuzusetzen, die ebenfalls einer Polymerisation zugänglich sind und so zu einer Copolymerisation führen. Auf diesem Weg lassen sich die Eigenschaften der Beschichtung in gewissem Rahmen modifizieren. Für diesen Zweck geeignete ungesättigte Verbindungen sind z.B. reaktive Acrylat- und Methacrylatmonomere wie Dipropylenglykoldiacrylat, Tripropylenglykoldiacrylat, Trimethylolpropantriacrylat, Pentaerythrittri(tetra)acrylat, ethoxyliertes Bisphenol-A-dimethacrylat, Bisgma-monomer, Urethandimethacrylat, 1,6-Hexandioldimethacrylat, 1,6-Hexandioldiacrylat und entsprechende Präpolymere.

Neben der Mitverwendung von copolymerisierbaren Verbindungen in der Lacklösung können die Eigenschaften der isolierenden Beschichtung auch auf andere Art und Weise modifiziert werden, z.B. durch Variation der Härtungsbedingungen. So wurde z.B. gefunden, daß bei der thermischen Härtung unter sauerstoffhaltiger Atmosphäre sich Carbonylgruppen auf der Oberfläche bilden, die sich bezüglich der Haftung im späteren Metallisierungsschritt vorteilhaft bemerkbar machen können.

Neben den oben erwähnten ungesättigten Monomeren kann die Lacklösung weiterhin übliche Zusätze enthalten, wie z.B. Füllstoffe, beispielsweise Glimmer, Glasflocken und Quarzteilchen, Pigmente, Verlaufsmittel und dergleichen. Bei der Auswahl von Art und Menge der Zusätze sollte darauf geachtet werden, daß dadurch insbesondere die elektrischen Eigenschaften des gewünschten isolierenden Überzugs nicht merklich beeinträchtigt werden.

Gemäß einer besonders bevorzugten Ausführungsform der vorliegenden Erfindung wird die Aufbringung des Polykondensats auf das Substrat durch Elektrotauchlackierung durchgeführt. Die Elektrotauchlackierung eignet sich insbesondere auch für die Beschichtung von unregelmäßig geformten Substraten und Substraten, die z.B. Bohrungen aufweisen.

Naturgemäß ist es für die Elektrotauchlackierung zwingend erforderlich, daß das Polykondensat Reste Z aufweist, die ihrerseits funktionelle Gruppen umfassen, die eine Ladung tragen können. Erfindungsgemäß geeignete Reste Z wurden bereits oben aufgezählt. Zweckmäßigerweise sind in den Ausgangsverbindungen A für die Herstellung eines derartigen Polykondensats mindestens 0,5 Molprozent Reste Z vorhanden, bezogen auf die Gesamtmolzahl der Gruppen V, X, Y, Z und R. Ganz allgemein kann festgestellt werden, daß die Zahl der aufladbaren Gruppen so groß sein sollte, daß eine zufriedenstellende (schnelle) Wanderung im elektrischen Feld erfolgt, daß aber bevorzugt nicht mehr derartige Gruppen vorhanden sind, als zu diesem Zweck unbedingt erforderlich sind.

Erfindungsgemäß besonders bevorzugt wird es, das zu beschichtende Substrat bei der Elektrotauchlakkierung als Kathode zu schalten, was zur Folge hat, daß das Polykondensat Gruppen aufweisen muß, die sich (durch Protonierung) positiv aufladen lassen, d.h. Gruppen der Formel $NR_2^{'}$. Die folgenden Ausführungen beziehen sich auf eine Abscheidung des Polykondensats an der Kathode, treffen sinngemäß aber auch auf eine Abscheidung an der Anode zu. Im übrigen gilt das im Zusammenhang mit der normalen Tauchlackierung hinsichtlich der Vorvernetzung des Polykondensats Ausgeführte auch für die Elektrotauchlackierung.

Typischerweise wird als Medium für die Elektrotauchlackierung Wasser verwendet. Die Kathode besteht aus dem (gegebenenfalls vorher oberflächenbehandelten) zu beschichtenden Substrat, z.B. einer Aluminiumplatte. Als Anode kann jedes elektrisch leitfähige Material verwendet werden, das unter den gegebenen Bedingungen nicht angegriffen wird. Zweckmäßigerweise verwendet man z.B. eine Edelstahlanode.

Da das (vorzugsweise vorvernetzte) Polykondensat trotz der Anwesenheit der Aminogruppen in Wasser in der Regel nicht ausreichend löslich ist, muß es für die Elektrotauchlackierung darin emulgiert werden. Zu diesem Zweck wird das Harz z.B. in einem geeigneten (unpolaren) Lösungsmittel gelöst, worauf man unter intensivem Rühren diese Lösung dem Wasser zugibt, bis sich eine Emulsion bildet. Um die Stabilität der Emulsion zu erhöhen oder die Bildung einer Emulsion überhaupt zu ermöglichen, kann es von Vorteil sein, einen üblichen Emulgator zuzusetzen. Vorzugsweise wird aber ohne Emulgator gearbeitet, damit die resultierende Beschichtung soweit wie möglich frei ist von Substanzen, die die elektrischen und chemischen Eigenschaften des Überzugs beeinträchtigen könnten. Es wurde gefunden, daß die Herstellung einer stabilen Emulsion auch ohne Emulgator möglich ist, wenn man das Harz in einem aromatischen Lösungsmittel, insbesondere Toluol oder Xylol, löst. Geeignete Gewichtsverhältnisse sind dabei 90 bis 95% Wasser und 5 bis 10% Polykondensat-Lösungsmittel-Mischung. Vorzugsweise ist in der Emulsion mindestens 1% Lösungsmittel vorhanden. Im Falle der Vorvernetzung des Polykondensats beträgt der Lösungsmittelanteil vorzugsweise mindestens 2,5%. Grundsätzlich nimmt mit zunehmendem Anteil des organischen Lösungsmittels die Stabilität der Emulsion zu, gleichzeitig neigt bei zu hohem Lösungsmittelanteil der abgeschiedene Lack aber zum Verlaufen.

Um das Polykondensat an der Kathode abscheiden zu können, muß dieses positiv aufgeladen werden, was dadurch bewerkstelligt wird, daß man die vorzugsweise vorhandenen Aminogruppen durch Zusatz einer Säure (entweder bereits zum Wasser oder erst zur Emulsion) protoniert. Für diesen Zweck eignen sich prinzipiell alle anorganischen und organischen Säuren wie z.B. Salzsäure, Perchlorsäure, Schwefelsäure, Salpetersäure und Phosphorsäure; Ameisensäure, Essigsäure, Propionsäure und Citronensäure. Erfindungsgemäß werden Phosphorsäure und organische Säuren bevorzugt. Die Menge der zugegebenen Säure soll vorzugsweise nur so groß sein, daß alle vorhandenen protonierbaren Gruppen protoniert werden. Insbesondere wird sogar ein leichter Unterschuß an Säure eingesetzt. Zu große Mengen an Säuren führen zu einer erhöhten Leitfähigkeit der Emulsion, was zur Folge haben kann, daß neben der elektrochemischen Abscheidung des Polykondensats an der Kathode in merklichem Ausmaß auch Elektrolysevorgänge auftreten, die naturgemäß nachteilig und deshalb unerwünscht sind. Aus diesem Grund sollte auch die Spannung nicht zu hoch gewählt werden.

Die optimalen Abscheidungsbedingungen variieren naturgemäß mit der Zähigkeit des Harzes, dem Substrat, der Zahl der vorhandenen geladenen Gruppe, der gewünschten Schichtdicke usw. Geeignete Spannungen liegen normalerweise im Bereich von 10 bis 50, insbesondere 20 bis 40 Volt. Zweckmäßigerweise wird während der Elektrotauchlackierung gerührt.

Nach der Elektrotauchlackierung kann die beschichtete Kathode von eventuell anhaftenden Emulsionströpfchen befreit werden, indem man sie mit Wasser, Alkohol oder einer anderen geeigneten Flüssigkeit abspült. Auch eventuell vorhandene Bohrungen können auf diese Weise freigespült werden. Daran schließt sich z.B. eine Trocknung an, gefolgt von einer Zwischen- bzw. Endhärtung, wie sie oben bereits beschrieben wurde. Auch in diesem Fall müssen eventuell zu verwendende thermische oder Photoinitiatoren bereits der Elektrotauchlackierungs-Lösung bzw. Emulsion zugesetzt werden.

An die Elektrotauchlackierung kann sich, nach vorheriger Zwischenhärtung, zum Zwecke der Vergrößerung der Schichtdicke eine normale Tauchbeschichtung (gegebenenfalls auch mehrere Tauchbeschichtungen) anschließen. Eine zweite Elektrotauchlackierung ist in der Regel nicht möglich, da der bereits vorhandene Überzug isolierend wirkt und somit den notwendigen Stromfluß verhindert.

Die Elektrotauchlackierung eignet sich insbesondere für Schichtdicken im Bereich von ≤ 1 bis 40 $\mu$m.

Zusammenfassend kann festgestellt werden, daß sich die erfindungsgemäß hergestellten isolierenden Beschichtungen durch eine hohe chemische und thermische Beständigkeit auszeichnen und auch hinsichtlich ihrer elektrischen Kenndaten äußerst zufriedenstellende Ergebnisse liefern. So lassen sich erfindungsgemäß mit einem isolierenden Überzug versehene Leiterplatten herstellen, die den an die herkömmlich verwendeten FR-4-Platten gestellten Anforderungen problemlos gerecht werden. Der erfindungsgemäße härtbare Isolationslack ist auch als Lötstopp- und Passivierungslack für elektronische Substrate verwendbar.

Durch den erfindungsgemäßen Einbau von aufladbaren Gruppen in das organisch vernetzbare Polykondensat ist es zudem möglich, das Substrat im Wege der Elektrotauchlackierung mit dem Isolationslack zu versehen, was insbesondere dann von Vorteil ist, wenn das Substrat unregelmäßig geformt ist (viele Abtropfkanten) bzw. Bohrungen aufweist.

Die folgenden Beispiele veranschaulichen die vorliegende Erfindung.

**Beispiel 1**

Eine Suspension aus 3 Liter Ethanol, 357 g 85%iger KOH (5,41 Mol) und 23,9 g (0,28 Mol) NaHCO$_3$ wurde zum Sieden erhitzt. Anschließend wurde unter Rühren (KPG-Rührer) und unter Rückfluß eine Mischung aus 265 g (1,875 Mol) Methylvinyldichlorsilan, 228 g (0,900 Mol) Diphenyldichlorsilan und 15,6 g (0,075 Mol) Tetraethoxysilan langsam zugetropft (innerhalb von 2,5 Stunden). Dabei bildete sich ein voluminöser weißer Niederschlag von KCl bzw. NaCl. Nach beendeter Zugabe der Silane wurde weiter 2 Stunden unter Rückfluß erhitzt und anschließend 15 Minuten im Eisbad gekühlt. Nach Zutropfen von 33,2 g (0,15 Mol) $\gamma$-Aminopropyltriethoxysilan unter Rühren innerhalb von 15 Minuten (Eisbad) wurde die Reaktionsmischung wieder aufgeheizt, 1 Stunde am Rückfluß erhitzt und daraufhin ca. 17 Stunden bei Raumtemperatur gerührt. Anschließend wurde der Niederschlag durch Druckfiltration (Glasfaser-Vorfilter plus Membranfilter mit einem Porendurchmesser von 1 $\mu$m) abgetrennt und mit 400 ml Ethanol nachgewaschen. Das klare Filtrat wurde bei ca. 80°C im Wasserstrahlvakuum (40 mbar) eingeengt. Zu dem klaren, noch heißen Rückstand wurden 450 ml Wasser gegeben, worauf man die Mischung 1 Stunde am Rückfluß erhitzte. Nachdem sich die organische Phase abgetrennt hatte (30 Minuten, Temperatur ca. 60 bis 70°C) wurde die wässrige Phase durch Abpipettieren abgetrennt. Anschließend wurde dieser Vorgang wiederholt. Schließlich wurde die organische Phase in ca. 1,4 Liter Petrolether (Siedepunkt 50 bis 70°C) gelöst und die Lösung zur vollständigen Entfernung noch gelöster Salze bzw. zu Neutralisation bis zur neutralen Reaktion mit Wasser (4 mal je 200 ml) ausgeschüttelt.

Nach Filtration über einen hydrophobierten Filter (Entfernung von suspendiertem Wasser) wurde die gewaschene Petroletherlösung am Rotationsverdampfer eingeengt. Der dickflüssige Rückstand wurde ca. 1 Stunde bei 150°C und 2 Stunden bei 180°C im Wasserstrahlvakuum ausgeheizt, wodurch ca. 335 g eines farblosen bis hellgelben Basisharzes erhalten wurden.

Das so erhaltene Basisharz wurde bei 215°C ca. 1 Stunde unter Rühren (KPG-Rührer) bei offenem Kolben unter Überleiten eines Argonstromes vorvernetzt. Das sehr zähe Harz wurde dann in ca. 240 g Toluol unter Verwendung eines IKA-Ultra-Turrax-Rührers innerhalb von 10 Minuten gelöst. Die nach Druckfiltration (Glasfaser-Vorfilter plus Membranfilter mit einer Porenweite von 1 $\mu$m) klare Lösung wurde durch Zusatz von Toluol auf den gewünschten Viskositätsbereich eingestellt.

Die so erhaltene Lacklösung wurde unter den folgenden Bedingungen für die Tauchbeschichtung eines Aluminiumsubstrats herangezogen:
Gewichtsverhältnis Polykondensat zu Toluol: ca. 1:0,77 (Viskosität ca. 134 cSt);

Anzahl der Beschichtungen: 2;

Ziehgeschwindigkeit: 3 cm/min;

Zwischenhärtung (nach der ersten Beschichtung):

1. Trocknen an der Luft; 2. 15minütiges Erhitzen auf 200°C;

Endhärtung: 1. Trocknen an der Luft; 2. 10minütiges Erhitzen bei 200°C; 3. 1stündiges Erhitzen auf 270°C (unter Luft).

Die erhaltenen Beschichtungen wiesen folgende Eigenschaften auf:

Schichtdicke: 30 bis 40 $\mu$m;

Aussehen: goldgelbe, sehr glatte Oberfläche;

Durchschlagsfestigkeit: 3 kV;

keine relevanten Veränderungen im Schwitzwassertest, chemischen Beständigkeitstest und Löttest.

Die elektrischen Eigenschaften eines analogen Überzugs, der unter Verwendung von Butylacetat als Lösungsmittel unter den folgenden Bedingungen erhalten wurde, sind in der beiliegenden Tabelle angegeben:

Gewichtsverhältnis Polykondensat zu n-Butylacetat: ca. 1:0,84 (Viskosität der Beschichtungslösung ca. 135 cSt);

Anzahl der Beschichtungen: 2;

Ziehgeschwindigkeit: 3 cm/min;

Zwischenhärtung (nach der ersten Beschichtung):

1. Trocknen an Luft; 2. 15minütiges Erhitzen bei 200°C;

Endhärtung: 1. Trocknen an der Luft; 2. 10minütiges Erhitzen auf 200°C; 3. 1stündiges Erhitzen auf 270°C (an Luft);

Schichtdicke: ca. 38 $\mu$m.

In einem weiteren Ansatz wurden der obigen Lacklösung vor der Tauchbeschichtung 6% (bezogen auf das Polykondensat) Irgacure® 184 zugesetzt. Danach wurde eine übliche Tauchbeschichtung durchgeführt. Das ausgetauchte Substrat wurde zur Entfernung des Lösungsmittels 10 Minuten auf 50°C erwärmt, woran sich eine UV-Härtung des Lackes durch 2minütige Bestrahlung mit einem Hg-Mitteldruckstrahler (1000 W) anschloß.

**Beispiel 2**

Unter Verwendung eines wie in Beispiel 1 hergestellten amingruppenhaltigen Polykondensats (Amingehalt 0,371 mMol pro g Harz) wurde eine Elektrotauchlackierung unter den folgenden Bedingungen durchgeführt:

Herstellung einer Emulsion aus 92,5 Gewichtsteilen Wasser (inklusive Phosphorsäure), 5 Gewichtsteilen vorvernetztem Harz und 2,5 Gewichtsteilen Toluol.

Beginn der Elektrotauchlackierung: 1,5 Stunden nach Herstellung der Emulsion;

Spannung: 30 V

Abscheidungszeit: 1 Minute;

Rührerdrehzahl: 200 U/min;

Temperatur: 25°C;

Elektrodenmaterial: Aluminium (Kathode) bzw. Edelstahl (Anode);

Elektrodenabstand: ca. 1,2 cm;

Nach der Elektrotauchlackierung wurde die Kathode mit Ethanol abgespült und gehärtet (10 min bei 200°C und 1 h bei 270°C). Schichtdicke: ca. 10 $\mu$m (sehr gleichmäßig)

Zur Erhöhung der Schichtdicke kann das so erhaltene Substrat einer normalen Tauchlackierung unterworfen werden.

9

T A B E L L E

Elektrische Eigenschaften des hergestellten Überzugs

| | Geforderte Werte für FR-4 (glasfaserverstärkte Epoxid-Harz-Platten) | Überzug von Beispiel 1 | |
|---|---|---|---|
| | | Trocken-Klima* | Feucht-Klima** |
| Oberflächenwiderstand $R_0$ (Ω) | $> 10^{10}$ | $4,2 \cdot 10^{13}$ | $5,5 \cdot 10^{12}$ |
| spez. Durchgangswiderstand $\rho_D$ (Ω·cm) | $> 10^{11}$ | $7,6 \cdot 10^{15}$ | $3,1 \cdot 10^{15}$ |
| Durchbruchfeldstärke $E_D$ (V/cm) | $3 \cdot 10^{5}$ | $8,5 \cdot 10^{5}$ | n. b. |
| Dielektrizitätskonstante $\varepsilon_R$ (bei 1 kHz) | $5,5$ | $2,85$ | $2,71$ |
| Verlustwinkel tan δ (bei 1 kHz) | $< 35 \cdot 10^{-3}$ | $7,7 \cdot 10^{-3}$ | $9,6 \cdot 10^{-3}$ |

\* Trocken-Klima: 50% rel. Luftfeuchtigkeit und 23°C (4 Tage)
\*\* Feucht-Klima: 92% rel. Luftfeuchtigkeit und 40°C (4 Tage)

**Beispiel 3**

Unter Verwendung eines wie in Beispiel 1 hergestellten amingruppenhaltigen Polykondensates (Amingehalt 0,249 mMol pro g Harz) wurde eine Elektrotauchlackierung unter den folgenden Bedigungen durchgeführt:

Emulsionszusammensetzung:

10

EP 0 354 489 B1

| $H_2O$ 94,4 | vorvernetztes Harz 4,7 | Xylol 0,9 |
|---|---|---|
| (in Massenteilen) | | |

Säure:              1/4 Äq. $CH_3CO_2H$ (bezogen auf den Amingehalt)
Spannung:           30 - 40 V
Rührerdrehzahl:     200 U/min.
Temperatur:         25 °C
Elektrodenmaterial: Aluminium (Kathode)
                    Edelstahl (Anode)
Elektrodenabstand:  1,2 cm Nach der Elektrotauchlackierung wurde die Kathode mit $H_2O$ gespült und gehärtet (10 min bei 200 °C und 1 h bei 270 °C). Schichtdicke bei 30 V (1 min) bis 40 V (2 min): ca. 13 $\mu$m bis 28 $\mu$m

Durchschlagsfestigkeit:    ab 20 $\mu$m ≥ 1 kV

**Patentansprüche**

1.  Verfahren zum Beschichten von elektrisch leitfähigen Substraten mit einem isolierenden Überzug, bei dem man mindestens zwei Siliciumverbindungen A, die jeweils mindestens eine an Silicium gebundene OH-Gruppe und/oder hydrolyseempfindliche Gruppe X, die ausgewählt ist aus Wasserstoff, Halogen, gegebenenfalls mit bis zu 3 Halogenen und $C_{1-4}$-Alkoxyresten substituiertem $C_{1-4}$-Alkoxy sowie $C_{1-4}$-Acyloxy und $NR'_2$ (R' = H und/oder $C_{1-4}$-Alkyl), aufweisen, wobei mindestens eine dieser Silicium-Verbindungen zusätzlich mindestens einen Rest Y besitzt, der über mindestens eine Kohlenstoff-Kohlenstoff-Doppel- oder Dreifachbindung verfügt, und mindestens eine dieser Siliciumverbindungen mindestens einen Rest Z aufweist, der über eine Gruppe verfügt, die ausgewählt ist aus Gruppen der Formeln $-NR'_2$, $-SO_3H$ und -COOH, oder ein entsprechendes Oligomeres einer Polykondensation unterwirft, das resultierende Polykondensat als solches auf das Substrat aufbringt und den so erhaltenen Überzug durch Polymerisation unter Beteiligung der Reste Y aushärtet.

2.  Verfahren nach Anspruch 1, dadurch gekennzeichnet, daß der Rest Z eine Aminogruppe, Monoalkylaminogruppe oder Dialkylaminogruppe enthält.

3.  Verfahren nach einem der Ansprüche 1 und 2, dadurch gekennzeichnet, daß das Substrat durch Eintauchen in eine Lösung des Polykondensats mit diesem beschichtet wird.

4.  Verfahren nach einem der Ansprüche 1 und 2, dadurch gekennzeichnet, daß das Aufbringen des Polykondensats auf das Substrat durch Elektrotauchlackierung erfolgt.

5.  Verfahren nach einem der Ansprüche 1 bis 4, dadurch gekennzeichnet, daß es sich bei dem elektrisch leitfähigen Substrat um ein Metall, insbesondere Aluminium, Kupfer und Eisen, oder eine entsprechende Metallegierung handelt.

6.  Verfahren nach einem der Ansprüche 1 bis 5, dadurch gekennzeichnet, daß die Polymerisation radikalisch, insbesondere unter Verwendung von UV-Licht, durchgeführt wird.

7.  Verfahren nach einem der Ansprüche 1 bis 6, dadurch gekennzeichnet, daß die hydrolyseempfindlichen Gruppen X ausgewählt werden aus Halogen, insbesondere Chlor, $C_{1-4}$-Alkoxy und $C_{1-4}$-Acyloxy.

8.  Verfahren nach einem der Ansprüche 1 bis 7, dadurch gekennzeichnet, daß die Reste Y ausgewählt werden aus Vinyl und $\gamma$-Methacryloxypropyl.

9.  Verfahren nach einem der Ansprüche 1 bis 8, dadurch gekennzeichnet, daß die Reste Z ausgewählt werden aus $\gamma$-Aminopropyl, N-$\beta$-Aminoethyl-$\gamma$-aminopropyl und den entsprechenden N-Methyl(Ethyl)- und N,N-Dimethyl(Diethyl)substituierten Resten.

10. Verfahren nach einem der Ansprüche 1 bis 9, dadurch gekennzeichnet, daß in den Verbindungen A zusätzlich weichmachende Gruppen V, insbesondere Phenylreste, vorhanden sind.

11

EP 0 354 489 B1

**11.** Verfahren nach einem der Ansprüche 1 bis 10, dadurch gekennzeichnet, daß die Verbindungen A mindestens eine Verbindung umfassen, die drei oder vier, vorzugsweise vier, an Silicium gebundene hydrolyseempfindliche Gruppen X oder OH-Gruppen aufweist.

**12.** Härtbarer Isolationslack, erhältlich durch alkalische Polykondensation von monomeren Siliciumverbindungen A, in denen die an Silicium gebundenen Gruppen der Kategorien V, X, Y, Z, die wie in den Ansprüchen 1 und 10 definiert sind, und R (R = gesättigte aliphatische Kohlenwasserstoffgruppe, vorzugsweise mit 1 bis 8 Kohlenstoffatomen) in folgenden Mengen, bezogen auf die Gesamtmolzahl dieser Gruppen, vorhanden sind:
35 bis 75 Molprozent, vorzugsweise 45 bis 60 Molprozent X und/oder OH;
5 bis 30 Molprozent, vorzugsweise 10 bis 20 Molprozent Y;
bis zu 10 Molprozent, vorzugsweise bis zu 5 Molprozent Z;
5 bis 30 Molprozent, vorzugsweise 10 bis 20 Molprozent V;
0 bis 30 Molprozent, vorzugsweise 5 bis 25 Molprozent R.

**13.** Härtbarer Isolationslack, dadurch gekennzeichnet, daß er erhältlich ist durch Polykondensation in Anwesenheit von Alkali von
(a) 55 bis 75 Molprozent, bezogen auf die Gesamtmolzahl der Siliciumverbindungen A, mindestens einer Verbindung, die ausgewählt ist aus $\gamma$-Methacryloxypropyltrimethoxysilan, Vinyltrichlorsilan, Methylvinyldichlorsilan, Vinyltrimethoxysilan, Vinyltriethoxysilan und Vinyl-tris($\beta$-methoxyethoxy)silan;
(b) 24 bis 40 Molprozent, bezogen auf die Gesamtmolzahl der Siliciumverbindungen A, mindestens einer Verbindung, die ausgewählt ist aus Diphenyldichlorsilan, Diphenyldimethoxysilan und Diphenyldiethoxysilan;
(c) 1 bis 5 Molprozent, bezogen auf die Gesamtmolzahl der Siliciumverbindungen A, mindestens einer Verbindung, die ausgewählt ist aus Tetrachlorsilan, Tetramethoxysilan, Tetraethoxysilan, Tetra-(i-propoxy)silan, Tetra(n-propoxy)silan und Tetrabutoxysilan;
(d) bis zu 10 Molprozent, bezogen auf die Gesamtmolzahl der Siliciumverbindungen A, mindestens einer Verbindung, die ausgewählt ist aus $\gamma$-Aminopropyltrimethoxysilan, $\gamma$-Aminopropyltriethoxysilan, $\gamma$-Aminopropylmethyldiethoxysilan und N-$\beta$-Aminoethyl-$\gamma$-aminopropyl-trimethoxysilan und den entsprechenden N-Mono- bzw. N,N-Di-methyl- bzw. -ethyl-silanen.

**Claims**

**1.** Process for coating electrically conductive substrates with an insulating coating, wherein at least two silicon compounds A, each of which has at least one OH group and/or group X susceptible to hydrolysis and selected from hydrogen, halogen, $C_{1-4}$ alkoxy, optionally substituted with up to 3 halogen atoms and $C_{1-4}$ alkoxy radicals, $C_{1-4}$ acyloxy and $NR'_2$ (R' = H and/or $C_{1-4}$ alkyl) bonded to silicon, at least one of said silicon compounds having additionally a radical Y which has at least one carbon-to-carbon double or triple bond and at least one of said silicon compounds having at least one radical Z which has a group selected from groups of formulae $-NR'_2$, $-SO_3H$ and $-COOH$, or a corresponding oligomer are subjected to polycondensation, the resulting polycondensate is applied as such onto the substrate and the coating thus obtained is cured by polymerization with participation of the radicals Y.

**2.** Process according to claim 1, characterized in that the radical Z contains an amino group, a monoalkyl amino group or a dialkyl amino group.

**3.** Process according to any one of claims 1 and 2, characterized in that the substrate is coated with the polycondensate by immersing it into a solution of the latter.

**4.** Process according to any one of claims 1 and 2, characterized in that the polycondensate is applied onto the substrate by electro dip-coating.

**5.** Process according to any one of claims 1 to 4, characterized in that the electrically conductive substrate is a metal, particularly aluminum, copper and iron, or a corresponding metal alloy.

**6.** Process according to any one of claims 1 to 5, characterized in that a radical polymerization, particularly with use of UV light, is conducted.

12

7. Process according to any one of claims 1 to 6, characterized in that the groups X susceptible to hydrolysis are selected from halogen, particularly chlorine, $C_{1-4}$ alkoxy and $C_{1-4}$ acyloxy.

8. Process according to any one of claims 1 to 7, characterized in that the radicals Y are selected from vinyl and $\gamma$-methacryloxy propyl.

9. Process according to any one of claims 1 to 8, characterized in that the radicals Z are selected from $\gamma$-aminopropyl, N-$\beta$-aminoethyl-$\gamma$-aminopropyl and the corresponding N-methyl(ethyl) and N,N-dimethyl-(diethyl) substituted radicals.

10. Process according to any one of claims 1 to 9, characterized in that the compounds A additionally contain plasticizing groups V, particularly phenyl radicals.

11. Process according to any one of claims 1 to 10, characterized in that the compounds A comprise at least one compound having three or four, preferably four, groups X susceptible to hydrolysis or OH groups bonded to silicon.

12. Curable insulating coating composition, obtainable by alkaline polycondensation of monomeric silicon compounds A, wherein the groups of the categories V, X, Y, Z, defined as in claims 1 and 10, and R (R = saturated aliphatic hydrocarbon group, preferably having 1 to 8 carbon atoms) bonded to silicon are present in the following amounts, based on the total number of mols of said groups:
   35 to 75 mol percent, particularly 45 to 60 mol percent of X and/or OH;
   5 to 30 mol percent, particularly 10 to 20 mol percent of Y;
   up to 10 mol percent, particularly up to 5 mol percent of Z;
   5 to 30 mol percent, particularly 10 to 20 mol percent of V;
   0 to 30 mol percent, particularly 5 to 25 mol percent of R.

13. Curable insulating coating composition, characterized in that it is obtainable by polycondensation in the presence of alkali of
   (a) 55 to 75 mol percent, based on the total number of mols of silicon compounds A, of at least one compound selected from $\gamma$-methacryloxypropyl trimethoxysilane, vinyl trichlorosilane, methylvinyl dichlorosilane, vinyl trimethoxysilane, vinyl triethoxysilane and vinyltris($\beta$-methoxyethoxy)silane;
   (b) 24 to 40 mol percent, based on the total number of mols of silicon compounds A, of at least one compound selected from diphenyldichlorosilane, diphenyldimethoxysilane and diphenyldiethoxysilane;
   (c) 1 to 5 mol percent, based on the total number of mols of silicon compounds A, of at least one compound selected from tetrachlorosilane, tetramethoxysilane, tetraethoxysilane, tetra(i-propoxy)-silane, tetra(n-propoxy)silane and tetrabutoxysilane;
   (d) up to 10 mol percent, based on the total number of mols of silicon compounds A, of at least one compound selected from $\gamma$-aminopropyl trimethoxysilane, $\gamma$-aminopropyl triethoxysilane, $\gamma$-aminopropylmethyl diethoxysilane and N-$\beta$-aminoethyl-$\gamma$-aminopropyl trimethoxysilane and the corresponding N-mono- and the respective N,N-di-methyl and ethyl silanes.

**Revendications**

1. Procédé pour appliquer sur des substrats électriquement conducteurs un revêtement isolant, procédé selon lequel on soumet au moins deux composés de silicium A [qui présentent chacun au moins un groupe OH fixé sur du silicium et/ou un groupe X sensible à une hydrolyse, choisi parmi un atome d'hydrogène, un atome d'halogène, un groupe alcoxy en $C_1$ à $C_4$ (ainsi qu'un groupe acyloxy en $C_1$ à $C_4$) (portant éventuellement comme substituant(s) jusqu'à 3 atomes d'halogène et restes alcoxy en $C_1$ à $C_4$) et $NR'_2$ (R' = H et/ou un groupe alkyle en $C_1$ à $C_4$), au moins l'un de ces composés du silicium possédant en outre au moins un reste Y, comportant au moins une double ou une triple liaison carbonecarbone, et au moins l'un de ces composés du silicium présentant au moins un reste Z comportant un groupe choisi parmi les groupes de formule $-NR'_2$, $SO_3H$ et $-COOH$], ou un oligomère correspondant, à une polycondensation, on applique tel quel le polycondensat résultant sur le substrat et l'on fait durcir, par polymérisation impliquant les restes Y, le revêtement ainsi obtenu.

**2.** Procédé selon la revendication 1, caractérisé en ce que le reste Z contient un groupe amino, un groupe monoalkylamino ou un groupe dialkylamino.

**3.** Procédé selon l'une des revendications 1 et 2, caractérisé en ce que, par immersion du substrat dans une solution du polycondensat, on revêt le susbtrat avec ce polycondensat.

**4.** Procédé selon l'une des revendications 1 et 2, caractérisé en ce que l'application du polycondensat sur le substrat a lieu par trempage électrophorétique.

**5.** Procédé selon l'une des revendications 1 à 4, caractérisé en qu'il s'agit, pour le substrat électriquement conducteur, d'un métal, notamment l'aluminium, le cuivre et le fer, ou d'un alliage métallique correspondant.

**6.** Procédé selon l'une des revendications 1 à 5, caractérisé en ce que la polymérisation est conduite par voie radicalaire, en particulier avec utilisation de la lumière ultra-violette.

**7.** Procédé selon l'une des revendications 1 à 6, caractérisé en ce que les groupes X sensibles à une hydrolyse sont choisis parmi des atomes d'halogène(s), notamment le chlore, et des groupes alcoxy en $C_1$ à $C_4$ et acyloxy en $C_1$ à $C_4$.

**8.** Procédé selon l'une des revendications 1 à 7, caractérisé en ce que les restes Y sont choisis parmi des restes vinyle, et $\gamma$-méthacryloxypropyle.

**9.** Procédé selon l'une des revendications 1 à 8 , caractérisé en ce que les restes Z sont choisis parmi des restes $\gamma$-aminopropyle, N-$\beta$-aminoéthyl-$\gamma$-aminopropyle et les restes à substituants N-méthyl-(éthyl)-et N,N-diméthyl(diéthyl) correspondants.

**10.** Procédé selon l'une des revendications 1 à 9 caractérisé en ce que les composés A comprennent en outre des groupes V plastifiants, en particulier des restes phényles.

**11.** Procédé selon l'une des revendications 1 à 10, caractérisé en ce que les composés A comprennent au moins un composé présentant, fixés sur le silicium, trois ou quatre, avantageusement quatre, groupes X sensibles à l'hydrolyse ou groupes OH.

**12.** Vernis isolant durcissable, que l'on peut obtenir par polycondensation alcaline de composés monomères du silicium A, dans lesquels les groupes fixés sur le silicium et appartenant aux catégories V, X, Y et Z, telles que ces catégories sont définies dans les revendications 1 à 10, et R (R représentant un groupe hydrocarboné aliphatique saturé, comportant avantageusement 1 à 8 atomes de carbone) sont présents selon les quantités suivantes, par rapport au nombre total de moles de ces groupes :
35 à 75 moles %, avantageusment 45 à 60 moles % de X et/ou OH;
5 à 30 moles %, avantageusement 10 à 20 moles % de Y;
jusqu'à 10 moles % , avantageusement jusqu'à 5 % de Z;
5 à 30 moles %, avantageusement 10 à 20 moles % de V;
0 à 30 moles %, avantageusmeent 5 à 25 modes % de R.

**13.** Vernis isolant durcissable, caractérisé en ce qu'on peut l'obtenir par polycondensation, en présence d'une substance alcaline, de
a) 55 à 75 moles %, par rapport au nombre total des modes des composés de silicium A, d'au moins un composé choisi parmi le $\gamma$-méthacryloxy propyltriméthoxy silane, le vinyl trichlorosilane, de méthylvinyldichlorosilane, le vinyltriméthoxysilane, le vinydtriéthoxysidane et le vinyltris ($\beta$-méthoxyéthoxy)silane;
b) 24 à 40 moles %, par rapport au nombre total des moles des composés de silicium A, d'au moins un composé choisi parmi le diphényldichlorosilane, le diphényldiméthoxysilane, et de diphényldiéthoxysilane;
c) 1 à 5 moles %, par rapport au nombre total des moles des composés de silicium A, d'au moins un composé choisi parmi le tétrachlorosilane, le tétraméthoxysilane, de tétraéthoxysilane, de tétra(i-propoxy)-silane, le tétra(n-propoxy)silane et le tétrabutoxysilane;

d) jusqu'à 10 moles %, par rapport au nombre total des moles des composés de silicium A, d'au moins un composé choisi parmi le γ-aminopropyltriméthoxysilane, le γ-aminopropyltriéthoxysilane, le γ-aminopropylméthyldiéthoxysilane, et le N-β-aminoéthyl-γ-aminopropyl-triméthoxysilane et les N-mono-méthyl-, N-mono-éthyl-, ou N,N-diméthyl- ou N,N-diéthyl-silanes correspondants.